# EUROPEAN PATENT SPECIFICATION

(11) **EP 1 970 464 B1**
(45) Date of publication and mention of the grant of the patent: **03.03.2010**
(21) Application number: 05826678.4
(22) Date of filing: 16.12.2005
(51) Int. Cl.: C23C 14/32, H01J 37/32

(54) **CATHODE EVAPORATION MACHINE**
KATHODENVERDAMPFUNGSMASCHINE
MACHINE D'EVAPORATION CATHODIQUE

(43) Date of publication of application: 17.09.2008
(73) Proprietor: FUNDACION TEKNIKER, 20600 Eibar-Guipuzcoa (ES)
(72) Inventor: GOIKOETXEA LARRINAGA, Josu, E-20600 Eibar (guipuzcoa) (ES)
(74) Representative: Carpintero Lopez, Francisco
(86) International application number: PCT/ES2005/000687
(87) International publication number: WO 2007/068768

(56) References cited:
- EP-A- 1 382 711
- DE-A1- 10 127 013
- DE-C1- 10 010 448
- ES-T3- 2 228 830
- US-A- 4 734 183
- US-A- 4 927 513
- US-A- 5 022 978
- US-A- 5 160 595
- US-A- 5 298 136
- US-A- 5 861 088

## Description

### Technical Field of the Invention

The invention is encompassed in the field of arc evaporators and, more specifically, in the field of arc evaporators including a magnetic guide system of the arc.

### Background of the Invention

The arc evaporators are machines intended for evaporating an electrically conductive material, such that said material can move through a chamber (in which a vacuum or very low pressure state is usually established) to be deposited on a surface of a part to be coated with the material. In other words, this type of machine is used for coatings of parts and surfaces.

The arc evaporator machines usually comprise, in addition to the chamber itself, at least one anode and at least one cathode between which an electric arc is established. This arc (which in a typical case can represent an 80 A current which is applied under a 22 V voltage) impacts on a point of the cathode (known as the cathode point) and causes at said point an evaporation of the material of the cathode. Therefore, the cathode is formed from the material which is to be used for the coating, normally in the form of a plate (for example, in the form of a disc) of said material. To maintain the arc and/or to aid in establishing the arc, a small amount of gas is usually introduced in the chamber. The arc causes an evaporation of the material in the inner surface of the cathode (i.e., on the surface of the cathode that is in contact with the inside of the chamber), in correspondence with the points where the arc impacts on the surface. This inner surface can be opposite the part or surface which is to be coated, so that the material vaporized by the arc is deposited on said part or surface. To prevent overheating of the cathode, a coolant fluid (for example, water) is frequently applied on the cathode, for example, on the outer surface of the cathode.

At all times, the arc (or, in the case of a system with multiple arcs, each arc) impacts on a specific point in which the evaporation of the cathode occurs. The arc moves on the inner surface of the cathode, causing a wearing away of said surface in correspondence with the path followed by the arc in its movement. If no type of control is applied on the movement of the arc, said movement can be random, causing a rather non-homogenous wearing away of the cathode, which can involve poor utilization of the material of the cathode, the cost of which per unit can be rather high.

To prevent or reduce the random nature of the movement of the arc for the purpose of making the wearing away of the cathode more homogenous, control or magnetic guidance systems for controlling the movement of the arc have been developed. These guidance systems form and modify magnetic fields affecting the movements of the electric arc, whereby making it possible that the wearing away by evaporation of the cathode is more homogenous. In addition, these magnetic guides contribute to increasing the reliability of the arc evaporator, by making it impossible or difficult for the arc to move accidentally to a point that does not form part of the evaporation surface.

There are several patent or patent application publications that describe different systems of this type.

US-A-4673477 describes a magnetic guidance system using a permanent magnet which is moved by mechanical means in the rear part of the plate to be evaporated, such that the variable magnetic field generated by this permanent magnet causes a guidance of the electric arc on the cathode. This machine optionally also incorporates a magnetic winding surrounding the plate of the cathode for the purpose of reinforcing or reducing the force of the magnetic field in a direction perpendicular to the active surface of the cathode and to thus improve the guidance of the electrode. A problem of this machine is that the magnetic system of mobile permanent magnets is very mechanically complex and, therefore, expensive to implement and susceptible to breakdowns.

US-A-4724058 relates to a machine with a magnetic guide incorporating coils placed in the rear part of the cathode plate, guiding the electric arc in a single direction parallel to that followed by the coil. For the purpose of reducing the preferred wearing away effect in a single path, methods which attempt to weaken the guidance effect of the magnetic field are used such that a random component is overlaid on the field. Specifically, it has been provided that the magnetic field generated by the coil connects and disconnects such that most of the time the arc moves over the cathode randomly. A problem of this machine is that the guidance finally occurs for very little time, whereby it cannot guarantee precise and efficient control of the wearing away of the cathode plate.

US-A-5861088 describes a machine with a magnetic guide including a permanent magnet located in the center of the target and in its outer face, and a coil surrounding the mentioned permanent magnet, the assembly forming a magnetic field concentrator. The system is complemented with a second coil placed in the exterior of the evaporator. A problem of this machine is that the generated magnetic field is weak, which involves a weak guidance effect on the movement of the electric arc.

WO-A-021077318 (FUNDACION TEKNIKER, *et al*.) (corresponding to ES-T-2228830 and EP-A-1382711) describes an evaporator with a powerful operative magnetic guide using permanent magnets in a forward position which corresponds to the inside of the chamber, therefore it is necessary to incorporate means to cool the magnets when the chamber is used for coatings carried out at a high temperature (for example, for cutting tools, which require process temperatures of about 500ºC).

US-A-5298136 describes a magnetic guide for thick targets in circular evaporators, comprising two coils and a magnetic part with a special configuration which adapts to the edges of the target to be evaporated, such that the assembly operates with a single magnetic element, with two magnetic poles. However, for example, it has been verified that at least one of the alternative configurations which are described in US-A-5298136 is perhaps not adequate or suitable for moving the arc in a cathode arc evaporator. Specifically, computational analyses have been performed by finite elements of the magnetic fields, suggesting that the configuration shown in Figure 5 of US-A-5298136 in practice does not allow the movement of the path of the arc more than just a few millimeters; therefore this configuration involves an inefficient use of the evaporation target. The configuration of Figure 5 of US-A-5298136 is formed by a ring-shaped permanent magnet arranged such that it surrounds the target or cathode, and the end edge of which is at the same level as the active surface of the cathode or target. The second magnetic pole is located inside the permanent magnet. There is arranged in contact with the lower surface of the target and on it, and also being inside the permanent magnet, a coil resting on a support, formed as a base of the magnetic pole. In this configuration, the second magnetic pole and the coil are placed against the target at its lower face, and the permanent magnet clamps, with contact, the coil and the target. Furthermore, the upper edge of the magnet is flush with the active surface of the target.

In view of the deficiencies or imperfections of the known systems, the object of the invention is to provide an alternative configuration which, with a rather simple structure, allows controlling the cathode arc and moving it over a broad area of the cathode plate. More specifically, the invention provides a system which allows guiding the cathode point (the point of impact of the arc on the cathode) according to a path which can be chosen individually from among an infinite number of possible paths and which can span the entire inner surface of the cathode plate.

### Description of the Invention

The invention relates to a cathode evaporation machine, comprising an evaporation chamber configured to house a part or surface to be coated, a cathode assembly comprising a cathode element, and an anode. The cathode assembly and the anode are configured and arranged such that an arc can be established between the anode and the cathode element to cause an at least partial evaporation of the cathode element, and the cathode assembly further comprises a magnetic guidance system to guide the arc on the cathode element. This magnetic guidance system comprises a magnetic device comprising a central pole and a peripheral pole, and at least a first magnetic field generator and a second magnetic field generator configured to generate respective magnetic field components contributing to a total magnetic field in correspondence with the cathode element. At least the first magnetic field generator comprises at least a first coil arranged around at least one part of the magnetic device and configured to generate the corresponding magnetic field component in the magnetic device, such that by modifying a current through the first coil, the total magnetic field in correspondence with the cathode element can be modified. The peripheral pole has an end surface configured so that the magnetic field generated by the first magnetic field generator and second magnetic field generator has a higher intensity in correspondence with said end surface than in correspondence with adjacent surfaces of the magnetic device.

According to the invention, the distance between this end surface and the cathode element is at least 20 mm. It has been verified that with this separation between the end surface in question and the cathode element, a considerable increase of the possibilities of moving the point of attack of the electric arc on the cathode element is achieved; in principle, it may be possible to move the point of attack of the electric arc on the entire surface of the cathode element.

The distance between this end surface and the cathode element can be at least 30 mm, or at least 40 mm. For example, this distance can be more than 40 mm and less than 150 mm, for example, more than 40 mm and less than 75 mm. These distances generally allow obtaining good movement of the point of attack of the cathode arc, on the entire or substantially the entire surface of the cathode element.

According to a possible aspect of the invention, the end surface can be spaced at least 10 mm from the outermost level of the cathode element in a first direction perpendicular to said level. Also or alternatively, said end surface can be spaced at least 10 mm from the cathode element in a direction parallel to the general extension of said cathode element. These configurations allow obtaining a broad movement of the point of attack of the electric arc on the surface of the cathode element.

The magnetic device can comprise a support having the peripheral pole and the central pole, the support having a base from which a central protuberance forming the central pole extends. The support can further have a peripheral extension extending from the base in a direction substantially parallel to the central protuberance, said peripheral extension forming the peripheral pole. Said at least one coil can surround the central protuberance. The central protuberance can comprise a ferromagnetic material.

The support can have a general circular configuration and/or a substantially E-shaped cross section (in which case the central arm of the E corresponds to the central protuberance and the side arms of the E correspond to the peripheral pole).

The support can be made of a ferromagnetic material. The second magnetic field generator can comprise at least a second coil surrounding a part of the support different from the central protuberance, the second magnetic field generator comprising said second coil.

The support can be formed in part by ferromagnetic material and in part by permanent magnet material, in which case the second magnetic field generator can comprise the permanent magnet material. For example, the peripheral pole can comprise permanent magnet material.

The peripheral extension can comprise, at least partially, permanent magnet material. This permanent magnet material can have a magnetization direction perpendicular to the base or, for example, a magnetization direction at an acute angle with regard to the base.

In some possible embodiments of the invention, the central protuberance can at least partially comprise permanent magnet material, and/or the base can at least partially comprise permanent magnet material.

The protuberance can have an end surface spaced from the base, said surface being substantially planar and substantially parallel to the cathode element.

The protuberance can have at least one through channel to allow the passage of a coolant fluid (for example, water).

The peripheral pole can be located in correspondence with a peripheral edge of the cathode element, but spaced from said peripheral edge.

The machine can further comprise a system of ducts for the passage of a coolant fluid in correspondence with the cathode element, and/or a programmable system to supply current to the first coil.

The peripheral pole and the central pole can be located outside the evaporation chamber.

### Description of the Drawings

To complement the description and for the purpose of aiding to better understand the features of the invention according to practical embodiments thereof, a set of drawings is attached as an integral part of said description in which the following has been depicted with an illustrative and non-limiting character:
Figure 1 shows a schematic sectional depiction of a circular arc evaporator with an external powerful magnetic guide according to a possible embodiment of the invention.
Figure 2 shows a configuration corresponding to the state of the art (specifically, corresponding to Figure 5 of US-A-5298136).
Figure 3 shows an image of a magnetic field created by a configuration according to Figure 1, as results by calculating it by finite elements.
Figure 4, similarly to Figure 3, shows an image of a magnetic field created by the configuration shown in Figure 2 (calculated by finite elements; the same software package has been used to calculate the fields shown in Figures 3 and 4).
Figure 5 shows a graph of a magnetic field perpendicular to the surface of the evaporation target, calculated in the surface of the target, depending on the distance from the center of the target and for different currents circulating through the coil shown in Figure 1.
Figure 6, similarly to the previous figure, shows a graph of the magnetic field perpendicular to the surface of the evaporation target, calculated in the surface of the target, depending on the distance from the center of the target and for different currents circulating through the inner coil of the magnetic configuration of Figure 2.
Figure 7, similarly to Figures 5 and 6, shows a graph of the magnetic field perpendicular to the surface of the evaporation target, calculated in the surface of the target, depending on the distance from the center of the target and for different currents circulating through the outer coil of the magnetic configuration described in US-A-5298136.
Figures 8-14 show several alternative configurations of the magnetic device.
Figure 15 shows an alternative configuration of the invention in which permanent magnets are not used; its function is carried out by a coil outside the ferromagnetic core.

### Preferred Embodiment of the Invention

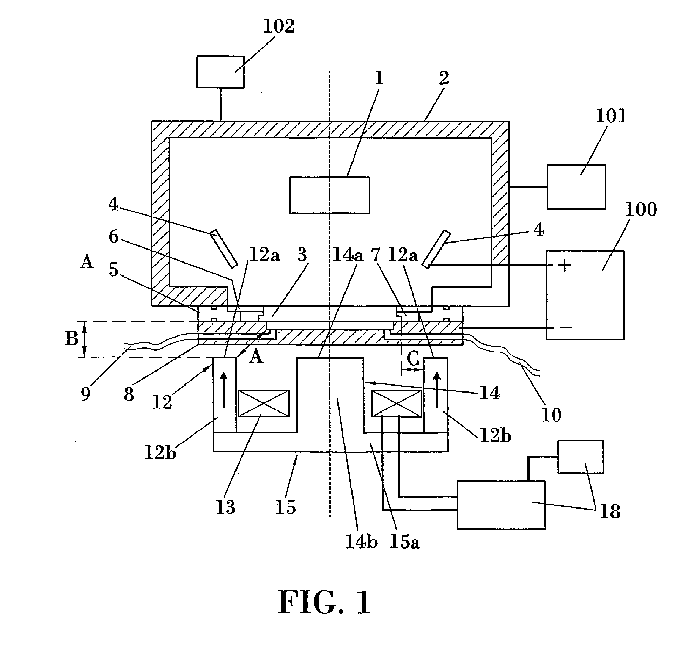

Figure 1 shows a machine according to a preferred embodiment of the invention, comprising an evaporation chamber 2 configured to house a part or surface to be coated 1, a cathode assembly comprising a cathode element 3, and an anode 4. The cathode element and the anode are connected to the negative and positive poles, respectively, of an electric power source 100, suitable for establishing and maintaining, under certain conditions, an electric arc between the cathode element 3 and the anode 4. Associated to the chamber there is a system of vacuum pumps 101 to establish a vacuum condition (or, better said, substantially vacuum condition) inside the chamber 2, as well as a gas injection system 102 to inject a small amount of gas, which can serve to facilitate establishing the electric arc between the cathode element 3 or cathode, and the anode 4 of the system.

The cathode element 3 forms what is usually referred to as the "target" to be evaporated, at least partially, with the cathode arc. The cathode element is located in an opening in one of the walls of the chamber 2, placed in a ring 7 screwed in a coolant part 8, associated to an inlet duct 9 of a coolant fluid, and to an outlet duct 10 of the coolant fluid, which passes between said inlet and outlet in contact with an outer surface of the cathode element to cool it. A part 5 made of plastic or ceramic material serves to fix the cathode assembly to the wall of the evaporation chamber 2; this part 5 provides electric insulation between the cathode assembly and the body of the chamber 2. In addition, the machine incorporates a protective plate 6, which can be made of boron nitride or of another suitable material, and which is located to protect the side of the cathode element 3 and the ring 7, such that the electric arc cannot impact on these parts of the assembly. This protective plate must be subject to periodic maintenance because in the course of operation of the arc it is gradually coated with electrically conductive materials, whereby its electric insulation and its effectiveness to prevent the striking of the arc gradually decrease.

Logically, and even though they are not shown in the figures, placed between the coolant part 8 and the cathode element there is at least one sealing joint to prevent the coolant fluid from being able to pass into the chamber 2.

In addition, the cathode assembly further comprises the magnetic guidance system to guide the arc on the cathode element 3. Specifically, in the embodiment shown in Figure 1, this magnetic guidance system comprises a magnetic device comprising a central pole 14 and a peripheral pole 12, and a first magnetic field generator and a second magnetic field generator configured to generate respective magnetic field components contributing to a total magnetic field in correspondence with the cathode element 3. The first magnetic field generator comprises a first coil 13 arranged around a central protuberance 14b extending from a base 15a of a support 15 forming part of the magnetic device. This protuberance 14b is configured to generate the corresponding magnetic field component in said magnetic device, such that by modifying a current through the first coil 13, the total magnetic field in correspondence with the cathode element 3 can be modified. The central protuberance 14b has an end surface 14a spaced from the base 15a; this surface is substantially planar and substantially parallel to the cathode element 3. In addition, the peripheral pole 12 has an end surface 12a configured so that the magnetic field generated by the first magnetic field generator and second magnetic field generator has a higher intensity in correspondence with this end surface 12a than in correspondence with adjacent surfaces of the magnetic device.

The support has a peripheral extension 12b extending from the base 15a in a direction substantially parallel to the central protuberance 14b; this peripheral extension 12b forms the peripheral pole 12. In this preferred embodiment, the peripheral extension is formed by permanent magnets and ends in the mentioned end surface 12a.

The magnetic device thus basically comprises a peripheral ring of permanent magnets, overlaid on an electromagnet with a body with a T-shaped cross section (forming the support 15 with its central protuberance 14b), made of a material with high magnetic permeability and little coercivity (for example, soft iron or another suitable ferromagnetic material) and with the central arm of the T surrounded by the coil 13.

Furthermore, the cathode assembly is provided with a programmable system 18 to supply current to the first coil 13. The programmable system can comprise an amplifier of the type normally used for feeding DC motors, and delivering a current controlled by a signal which is sent from a Programmable Logic Controller (PLC), such that it is possible to vary the current circulating through first coil 13 in a programmed manner.

According to the invention, the permanent magnets are located in correspondence with the outer edge of the cathode element, but spaced from the cathode element. Specifically, the distance A between the end surface 12a (corresponding to an end of the permanent magnets) and the cathode element 3, is at least 20 mm, for example, between 40 mm and 150 mm. It is appropriate that the end surface 12a is spaced a distance B of at least 10 mm from the outermost level of the cathode element 3, in a first direction perpendicular to said level, and a distance C of at least 10 mm from the cathode element 3, in a direction parallel to the general extension of said cathode element 3, as indicated in Figure 1.

This configuration allows establishing a point of attack of the arc which can be moved on the entire surface of the cathode element which is accessible from inside the chamber 2, and it further allows placing the cooling system 8 between the magnetic guidance system and the cathode element 3.

As can be seen, the magnetic guidance system of Figure 1 is completely outside the evaporation chamber 2, which facilitates the design and manufacture of the machine.

Figure 1 is a schematic drawing in which its relative proportions approximate the proportions of the evaporator for a circular evaporation target with a diameter of 100 mm.

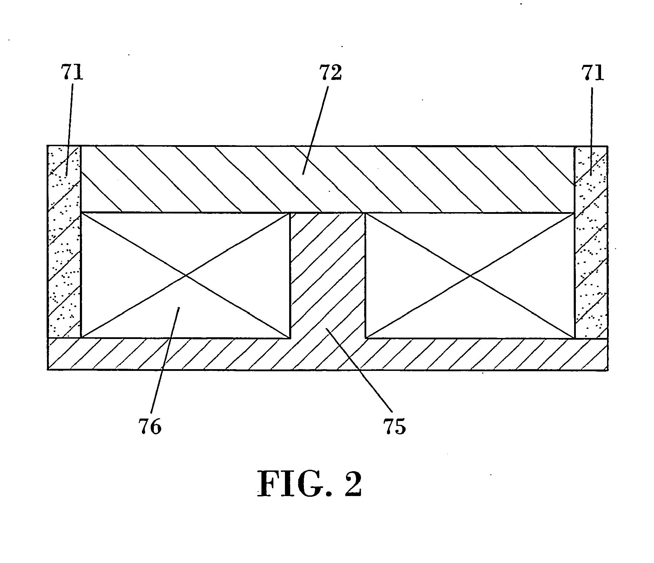

Figure 2 shows by way of example an embodiment which seems to form part of the state of the art and which, more specifically, seems to be reflected in US-A-5298136. This system comprises a cathode or evaporation target 72, a ferromagnetic core 75, a coil 76 and permanent magnets 71. The permanent magnets 71 are at the same level as the surface of the cathode element 72, which has been considered to be unsuitable for many applications because it does not seem to favor suitable guidance of the arc on the entire surface of the cathode element.

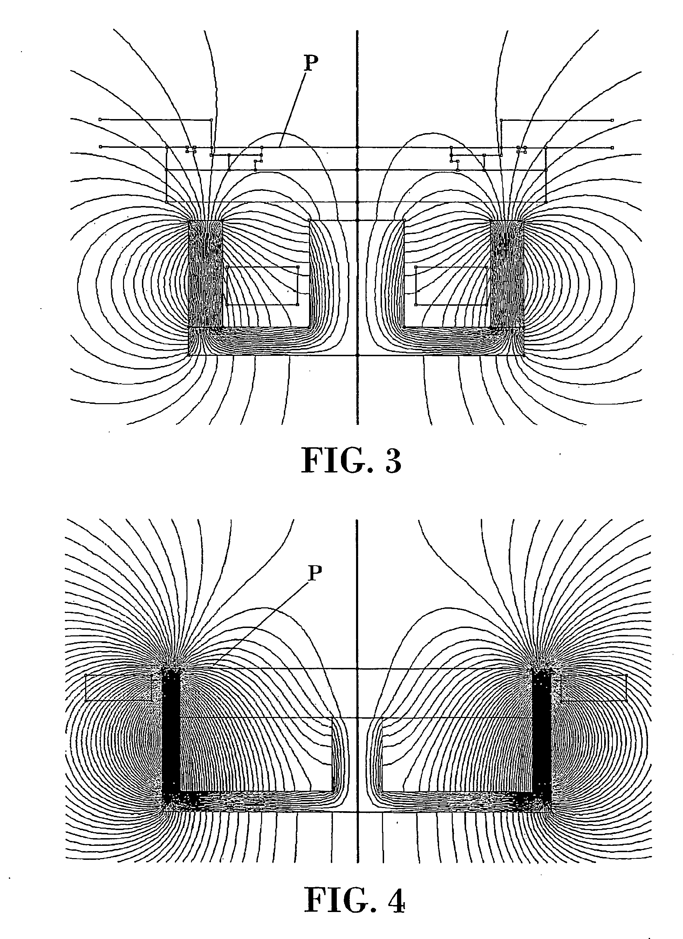

Figure 3 shows the lines of the magnetic field created by the permanent magnets when the coil is inactive, in the magnetic configuration according to the embodiment of the invention shown in Figure 1. The magnetic field has been calculated with a software package for calculating magnetic fields by finite elements. Point "P" indicates the point in which the magnetic field is parallel to the inner surface of the target (i.e., to the surface of the cathode element that is located in correspondence with the inside of the chamber and on which the cathode arc must act), or, in other words, the point of the surface of the target in which the normal component of the magnetic field (perpendicular to the surface of the target) is cancelled out. These points form a circular path on the surface of the target, which forms the path that the electric arc will follow in its movement.

Figure 4 shows the lines of the magnetic field created by the permanent magnets when the coil is inactive, in the magnetic configuration shown in Figure 2; the magnetic field has been calculated with the same software that has been used to calculate the magnetic field shown in Figure 3. Also in Figure 4, point "P" indicates the point in which the magnetic field is parallel to the inner surface of the target.

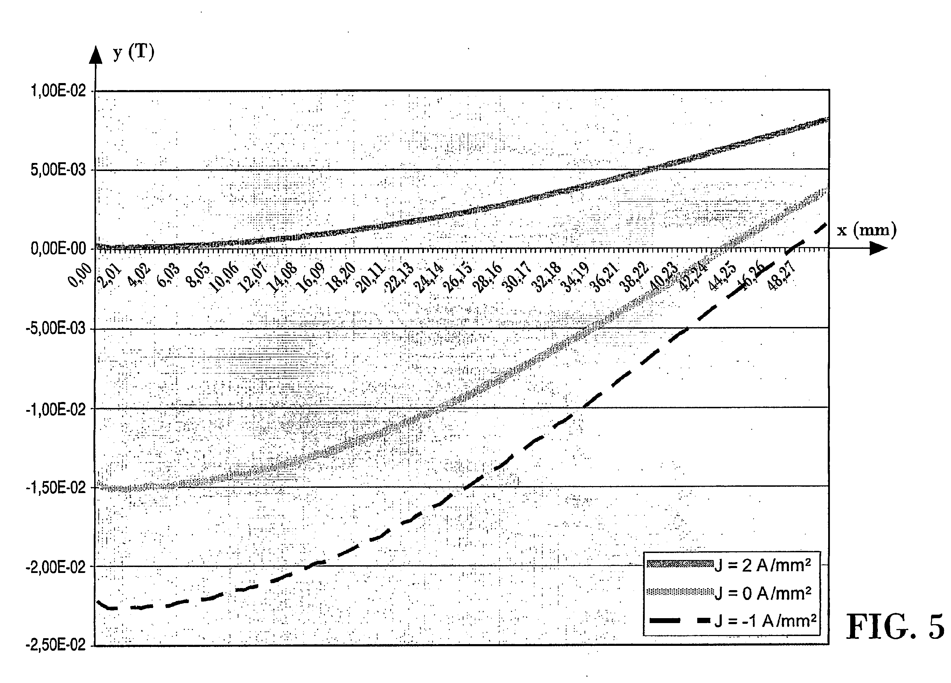

The relative proportions of the parts appearing in Figure 2 are not suitable for powerful permanent magnets, such as those manufactured from a neodymium-iron-boron or a cobalt-samarium base. It is possible that Figure 5 of US-A-5298136 is drawn thinking of the use of Alnico magnets, which were still the most frequent magnets at the time the corresponding patent application was filed. Therefore, when the simulations on which Figures 3 and 4 are based were made, Alnico V permanent magnets have been assumed. To assure that both simulations are comparable, a target with a diameter of 100 mm has further been used for both. Taking this as a reference, the simulation for Figure 2 has been carried out conserving the proportions between the parts appearing in Figure 5 of US-A-5298136.

Figure 5 shows a graph of the normal component of the magnetic field in the surface of the target ("y" axis, in Teslas (T)), depending on the distance from the center of the target ("x" axis, in mm), for different values of current density (2 A/mm², 0 A/mm² and -1 A/mm², respectively) made to circulate through the coil, all for the magnetic configuration shown in Figure 1. As previously indicated, the arc will follow the path formed by the points in which the magnetic field is parallel to the surface of the target, i.e., the points where the normal component is cancelled out. Therefore, it can be seen in this graph that for an inactive coil, J = 0 A/mm², the path is a circumference of 44 mm in radius. Similarly, for J = -1 A/mm², the path has a radius of 48 mm, very close to the edge of the target, whereas for J = 2 A/mm² the radius of the path is 3 mm, therefore it is virtually in the center.

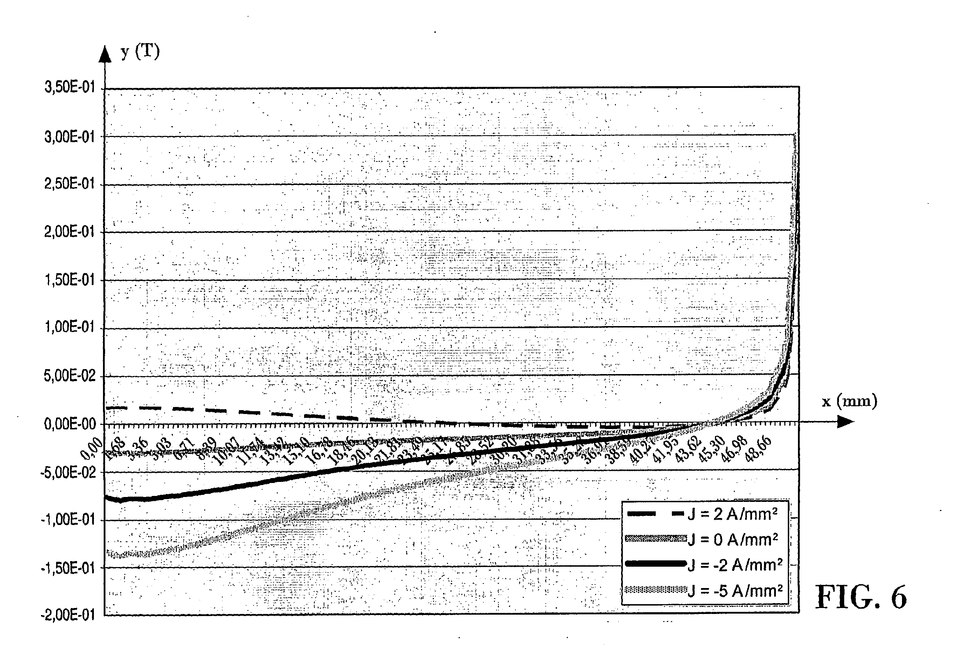

In contrast, Figure 6 shows the same graph (i.e., a graph of the normal component of the magnetic field in the surface of the target -"y" axis, in Teslas-, depending on the distance from the center of the target -"x" axis, in mm-, for different values of current density (J=2 A/mm², 0 A/mm², -2 A/mm², -5 A/mm², respectively) which is made to circulate through the coil) for the magnetic configuration of Figure 2 (applying what has been mentioned above with regard to that figure, *mutatis mutandis*). As can be seen, for all the reasonable values of currents in the coil, the normal magnetic field is cancelled out for a radius of about 44 mm, therefore the arc will follow this circular path independently of the intensity of the current circulating through the coil. The only modification that is obtained by varying the intensity of the coil is a slight increase or reduction of the intensity of the magnetic field, which will have a small influence on the degree of strength with which the magnetic field secures the arc to the established path, and it will also slightly influence the speed at which the arc moves when varying the intensity of the parallel magnetic field.

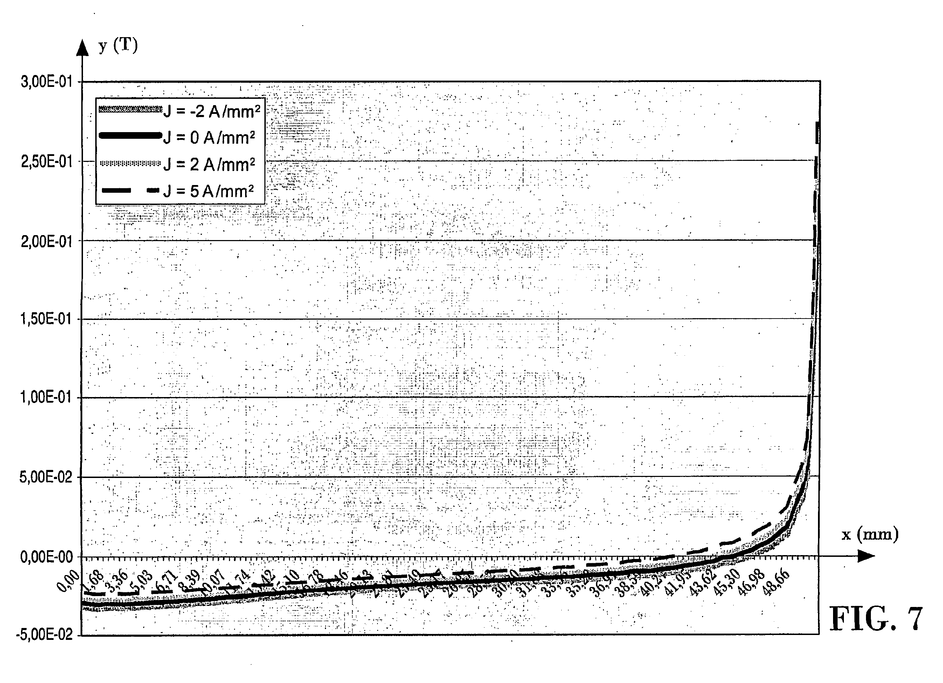

Figure 7 again shows a graph of the normal magnetic field for the magnetic configuration of Figure 2 (namely, a graph of the normal component of the magnetic field in the surface of the target -"y" axis, in Teslas-, depending on the distance from the center of the target -"x" axis, in mm-, for different values of current density (2 A/mm², 0 A/mm² and -2 A/mm², -5 A/mm², respectively) which is made to circulate through the coil) for the magnetic configuration of Figure 2 (applying what has been mentioned above with regard to that figure, *mutatis mutandis*), but this time using a coil outside the ferromagnetic core. In this case there is an exiguous variation in the radius of the path of the arc, from 40 mm in radius to 45 mm, despite the fact that the intensity must be varied to that end between -2 A/mm² and 5 A/mm², i.e., much more than in the configuration of Figure 1. This means that if one is based on the system proposed in Figure 2, it may possibly be necessary to adopt cooling systems with water to prevent the coils from overheating due to the mere passage of the current.

The main reason for the inability to vary the path of the arc with the action of the coils in the case of the configuration of Figure 2 may reside in the fact that the nearness of the permanent magnet (the field of which is barely altered by the coils) to the surface of the target makes the magnetic field in this point barely be affected by the field created by the coils. Therefore, the invention solves this problem by moving said permanent magnets (or the functionally corresponding elements of the magnetic device) away from the evaporation target. To offset the weakening of the magnetic field associated to the moving away of the permanent magnets, it may be appropriate to increase the size thereof. It is estimated that in the case of Figure 1, a separation of 20 mm between the permanent magnets and the target can be sufficient so that the action of a suitably designed coil can sweep the path of the arc in a range of practical utility. Moving it farther away can give a larger sweep range, but in return the magnetic field is reduced, therefore its beneficial effects on the performance of the arc decrease, or alternatively, it is necessary to incorporate larger or more powerful magnets. It is commonly considered that a guide with a parallel magnetic field, in the path of the arc, of about 15 Gausses (0.0015 Teslas) can be sufficient to suitably guide the arc, but the increase of the intensity of the magnetic field normally results in an improvement of the coating. In return, this requires the use of larger magnets or magnets with more energy, and even arc supply sources of better quality since the increase of the movement speed of the arc also involves an increase in the voltage of the arc and, therefore, in its instability, which must be offset by using a more reactive supply source of better quality. Therefore the choice of the magnetic intensity which must be used depends on the relative importance given to the different factors that have been mentioned.

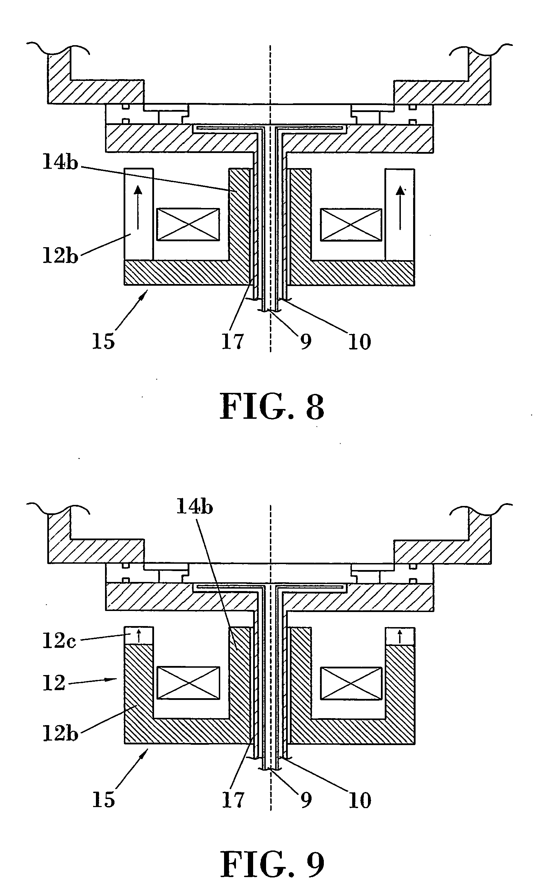

Figures 8-15 show some alternative configurations for the manufacture of the magnetic part of the magnetic guide, out of the many that can be conceived, essentially maintaining the character of the invention.

Figure 8 corresponds to an alternative embodiment of the magnetic guide in which the ferromagnetic core has a central through opening 17, through which the supply 9 and the return 10 of the coolant fluid can pass, as well as the supply of the current of the arc (which is not shown). The opening barely modifies the distribution of the magnetic field in the surface of the target and its impact in the sweep of the surface is very low, whereas this form of supply of the coolant fluid and of the current of the arc allows it to be carried out symmetrically, homogeneously, not affecting the wearing away profile of the target. The cooling can be sophisticated using radial or spiral channels. As in Figure 1, the peripheral extension 12b is formed by permanent magnets.

Figure 9 shows a configuration in which the Alnico magnets used in the simulation (which form the peripheral extension in Figure 8) have been replaced with a ferromagnetic part (forming part of the actual support 15) capped with a high-energy magnet 12c manufactured in neodymium-iron-boron or in cobalt-samarium, having the advantage of providing more energy and preventing the demagnetization problems of the Alnico magnet.

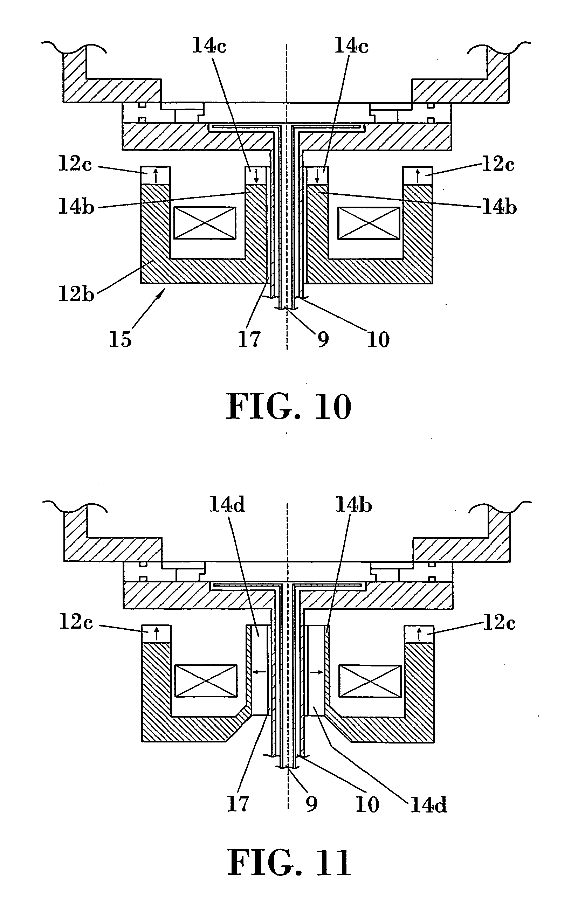

Figure 10 shows a configuration similar to Figure 9 but in which magnets 14c have also been added in the central pole, which contributes to increasing the intensity of the magnetic field.

Figure 11 is an alternative configuration to that of Figure 10, in which the magnets 14d of the central pole are radially magnetized, therefore a larger number of magnets can be placed, which aids in further increasing the field.

In these configurations the magnetization of the permanent magnets located in the central pole is such that it coincides with the direction in which the magnetic lines created by the peripheral magnets 12c arrive such that they reinforce them, without substantially modifying the distribution of lines created by the peripheral magnets 12c. If these magnets of the central pole 14c, 14d were magnetized in the reverse direction, they would oppose the flux created by the peripheral magnets 12c and could substantially alter the character of the magnetic field.

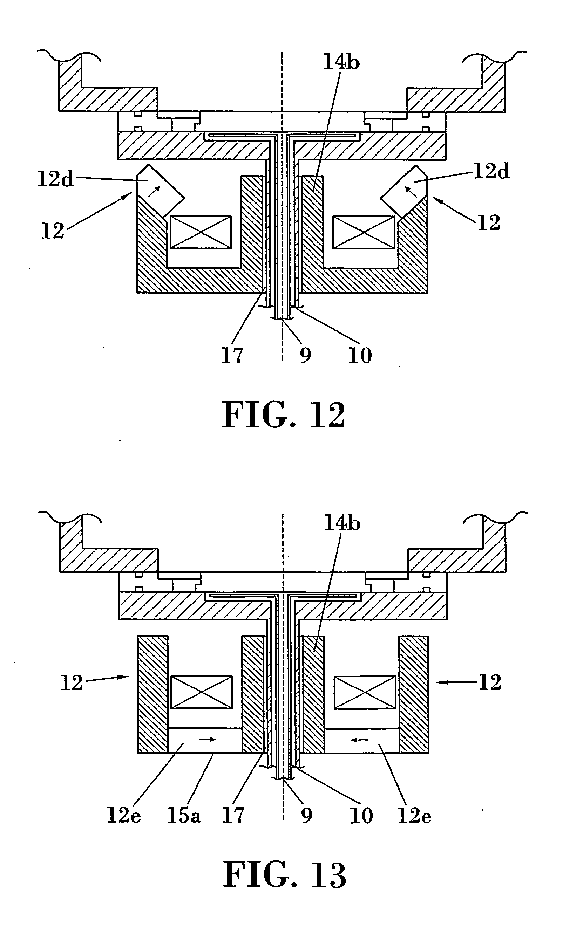

Figure 12 shows a configuration in which the peripheral magnets 12d are not magnetized vertically but rather with a certain inclination towards the center of the evaporator. This alteration modifies the location of the path created simply by the peripheral magnets, which can be advantageously used to equal the intensity that the coil must apply in both directions to drag the path to its practical limits.

Figure 13 shows a configuration in which the permanent magnets 12e are located in the horizontal plane instead of in the vertical arms. This configuration has the advantage of providing a large volume for the placement of magnets, therefore the latter can be lower energy magnets than those used in other configurations. For example, they can be of hard ferrites, instead of neodymium-iron-boron, which could be used in other configurations.

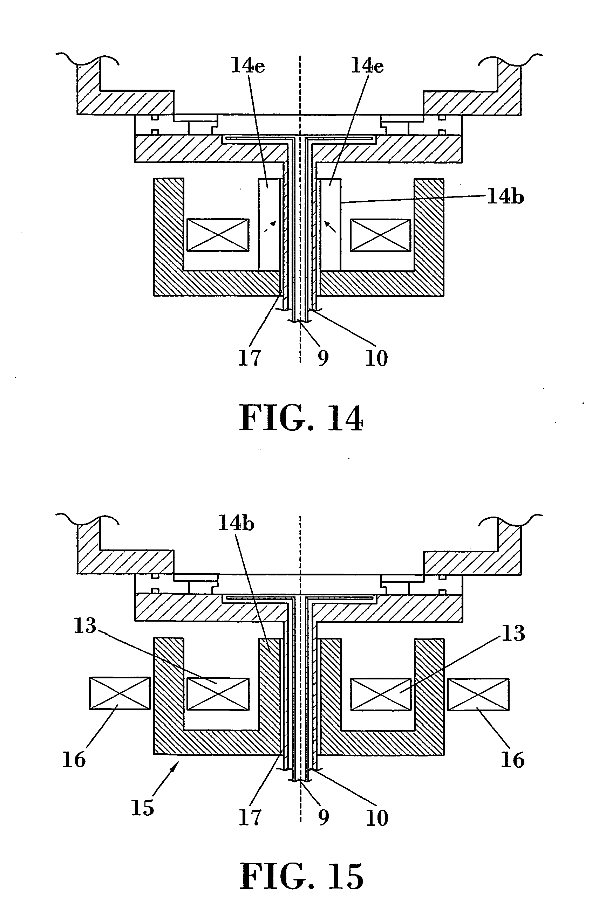

Figure 14 shows a configuration in which magnets are not used in the peripheral pole and the central pole is formed by a permanent magnet 14e with a magnetization that does not have to be strictly vertical but rather can be inwardly inclined.

Figure 15 shows a configuration in which permanent magnets have been discarded and their function is carried out by a coil 16 outside the magnetic assembly formed by the ferromagnetic core forming the support 15. Despite having less practical utility than the rest of the configurations described, circumstances can arise in which the extra flexibility provided by the outer coil can be advantageously used.

Additionally, all these configurations can be made compatible with a gas injection system through an insert placed in the center of the evaporation target to allow carrying out electronic ignition of the arc.

The configurations that have been described can even be combined with one another to create valid configurations, therefore it is obvious that the described configurations by no means deplete the possibilities of manufacturing different magnetic guides that substantially adapt to what has been described in this invention. Identical or similar elements have been indicated in this detailed description of several possible embodiments of the invention with the same reference numbers.

In this text the word "comprises" and its variants (such as "comprising", etc.) should not be interpreted as excluding, i.e., they do not exclude the possibility that what has been described includes other elements, steps etc.

In addition, the invention is not limited to the specific embodiments that have been described but rather also encompasses, for example, the variants that can be made by a person skilled in the art (for example, with regard to the choice of materials, dimensions, components, configuration, etc.), within that inferred from the claims.

## Claims

1. A cathode evaporation machine, comprising an evaporation chamber (2) configured to house a part or surface to be coated (1), a cathode assembly comprising a cathode element (3), and an anode (4),
the cathode assembly and the anode being configured and arranged such that an arc can be established between the anode (4) and the cathode element (3) to cause an at least partial evaporation of the cathode element (3),
the cathode assembly further comprising a magnetic guidance system to guide the arc on the cathode element (3),
said magnetic guidance system comprising a magnetic device comprising a central pole (14) and a peripheral pole (12), and at least a first magnetic field generator and a second magnetic field generator configured to generate respective magnetic field components contributing to a total magnetic field in correspondence with the cathode element (3), at least said first magnetic field generator comprising at least a first coil (13) arranged around at least one part (14b) of the magnetic device and configured to generate the corresponding magnetic field component in said magnetic device, such that by modifying a current through said first coil (13), said total magnetic field in correspondence with said cathode element (3) can be modified,
the peripheral pole (12) having an end surface (12a) configured so that the magnetic field generated by the first magnetic field generator and second magnetic field generator has a higher intensity in correspondence with said end surface (12a) than in correspondence with adjacent surfaces of the magnetic device;
**characterized in that**
the distance (A) between said end surface (12a) and the cathode element (3) is at least 20 mm.

2. The cathode evaporation machine according to claim 1, wherein said distance (A) is at least 30 mm.

3. The cathode evaporation machine according to claim 2, wherein said distance (A) is at least 40 mm.

4. The cathode evaporation machine according to claim 3, wherein said distance (A) is more than 40 mm and less than 150 mm.

5. A cathode evaporation machine according to any of the previous claims, wherein said end surface (12a) is spaced a distance (B) of at least 10 mm from the outermost level of the cathode element (3), in a first direction perpendicular to said level.

6. The cathode evaporation machine according to any of the previous claims, wherein said end surface (12a) is spaced a distance (C) of at least 10 mm from the cathode element (3), in a direction parallel to the general extension of said cathode element (3).

7. The cathode evaporation machine according to any of the previous claims, wherein the magnetic device comprises a support (15) having said peripheral pole (12) and said central pole (14), said support having a base (15a) from which a central protuberance (14b) forming said central pole (14) extends.

8. The cathode evaporation machine according to claim 7, wherein the support further has a peripheral extension (12b) extending from the base (15a) in a direction substantially parallel to the central protuberance (14b), said peripheral extension (12b) forming the peripheral pole (12).

9. The cathode evaporation machine according to claim 7 or 8, wherein said at least one coil (13) surrounds said central protuberance (14b).

10. The cathode evaporation machine according to claim 9, wherein said central protuberance (14b) comprises a ferromagnetic material.

11. The cathode evaporation machine according to any of claims 7-10, wherein said support (15) has a general circular configuration.

12. The cathode evaporation machine according to any of claims 7-11, wherein the support (15) is made of a ferromagnetic material.

13. The cathode evaporation machine according to any of claims 7-11, wherein the support is formed in part by ferromagnetic material and in part by permanent magnet material, said second magnetic field generator comprising said permanent magnet material.

14. The cathode evaporation machine according to claim 13, wherein the peripheral pole (12) comprises permanent magnet material.

15. The cathode evaporation machine according to claims 9 and 16, **characterized in that** said permanent magnet material has a magnetization direction perpendicular to the base.

16. The cathode evaporation machine according to claims 9 and 16, **characterized in that** said permanent magnet material has a magnetization direction at an acute angle with regard to the base.

17. The cathode evaporation machine according to claim 13, wherein said protuberance (14b) at least partially comprises permanent magnet material.

## Patentansprüche

1. Kathodenverdampfungsmaschine mit einer zum Aufnehmen eines zu beschichtenden Teils oder einer Fläche (1) ausgebildeten Verdampfungskammer (2), einer ein Kathodenelement (3) aufweisenden Kathodenanordnung, und einer Anode (4),
wobei die Kathodenanordnung und die Anode derart ausgebildet und angeordnet sind, dass ein Lichtbogen zwischen der Anode (4) und dem Kathodenelement (3) gebildet werden kann, um eine zumindest teilweise Verdampfung des Kathodenelements (3) zu bewirken,
wobei die Kathodenanordnung ferner ein magnetisches Führungssystem zum Führen des Lichtbogens auf dem Kathodenelement (3) aufweist,
wobei das magnetische Führungssystem eine magnetische Vorrichtung mit einem mittigen Pol (14) und einem randständigen Pol (12), und mindestens einen ersten Magnetfeldgenerator und einen zweiten Magnetfeldgenerator aufweist, die zum Erzeugen jeweiliger Magnetfeldkomponenten ausgebildet sind, welche zu einem dem Kathodenelement (3) entsprechenden Gesamtmagnetfeld beitragen, wobei zumindest der erste Magnetfeldgenerator mindestens eine erste Spule (13) aufweist, die um mindestens einen Teil (14b) der magnetischen Vorrichtung herum angeordnet und derart ausgebildet ist, dass sie die entsprechende Magnetfeldkomponente in der magnetischen Vorrichtung erzeugt, so dass durch das Modifizieren eines durch die erste Spule (13) fließenden Stroms das dem Kathodenelement (3) entsprechende Gesamtmagnetfeld modifiziert werden kann,
wobei der randständige Pol (12) eine Endfläche (12a) aufweist, die derart ausgebildet ist, dass das von dem ersten Magnetfeldgenerator und dem zweiten Magnetfeldgenerator erzeugte Magnetfeld in Bezug auf die
Endfläche (12a) eine größere Stärke als in Bezug auf benachbarte Flächen der magnetischen Vorrichtung hat,
**dadurch gekennzeichnet, dass**
der Abstand A zwischen der Endfläche (12a) und dem Kathodenelement (3) mindestens 20 mm beträgt.

2. Kathodenverdampfungsmaschine nach Anspruch 1, bei welcher der Abstand (A) mindestens 30 mm beträgt.

3. Kathodenverdampfungsmaschine nach Anspruch 2, bei welcher der Abstand (A) mindestens 40 mm beträgt.

4. Kathodenverdampfungsmaschine nach Anspruch 3, bei welcher der Abstand (A) größer als 40 mm und kleiner als 150 mm ist.

5. Kathodenverdampfungsmaschine nach einem der vorhergehenden Ansprüche, bei welcher die Endfläche (12a) von der äußersten Ebene des Kathodenelements (3) in einer zu der Ebene senkrechten ersten Richtung um einen Abstand (B) von mindestens 10 mm beabstandet ist.

6. Kathodenverdampfungsmaschine nach einem der vorhergehenden Ansprüche, bei welcher die Endfläche (12a) von dem Kathodenelement (3) in einer zu der allgemeinen Erstreckung des Kathodenelements (3) parallelen Richtung um einen Abstand (C) von mindestens 10 mm beabstandet ist.

7. Kathodenverdampfungsmaschine nach einem der vorhergehenden Ansprüche, bei welcher die magnetische Vorrichtung eine Stütze (15) mit dem randständigen Pol (12) und dem mittigen Pol (14) aufweist, wobei die Stütze (15) eine Basis (15a) aufweist, von welcher sich ein den mittigen Pol (14) bildender mittiger Vorsprung (14b) erstreckt.

8. Kathodenverdampfungsmaschine nach Anspruch 7, bei welcher die Stütze ferner eine randständige Erstrecklung (12b) aufweist, welche sich von der Basis (15a) in einer zu dem mittigen Vorsprung im Wesentlichen parallelen Richtung erstreckt, wobei die randständige Erstreckung (12b) des randständigen Pol (12) bildet.

9. Kathodenverdampfungsmaschine nach Anspruch 7 oder 8, bei welcher die mindestens eine Spule (13) den mittigen Vorsprung (14b) umgibt.

10. Kathodenverdampfungsmaschine nach Anspruch 9, bei welcher der mittige Vorsprung (14b) ein ferromagnetisches Material aufweist.

11. Kathodenverdampfungsmaschine nach einem der Ansprüche 7-10, bei welcher die Stütze (15) im Allgemeinen kreisförmig ausgebildet ist.

12. Kathodenverdampfungsmaschine nach einem der Ansprüche 7-11, bei welcher die Stütze (15) aus einem ferromagnetischen Material besteht.

13. Kathodenverdampfungsmaschine nach einem der Ansprüche 7-11, bei welcher die Stütze zum Teil aus ferromagnetischem Material und zum Teil aus Permanentmagnetmaterial gebildet ist, wobei der zweite Magnetfeldgenerator das Permanentmagnetmaterial aufweist.

14. Kathodenverdampfungsmaschine nach Anspruch 13, bei welcher der randständige Pol (12) Permanentmagnetmaterial aufweist.

15. Kathodenverdampfungsmaschine nach den Ansprüchen 9 und 14, **dadurch gekennzeichnet, dass** das Permanentmagnetmaterial eine zu der Basis senkrechte Magnetisierungsrichtung aufweist.

16. Kathodenverdampfungsmaschine nach den Ansprüchen 9 und 14, **dadurch gekennzeichnet, dass** das Permanentmagnetmaterial eine in Bezug auf die Basis unter einem spitzen Winkel verlaufende Magnetisierungsrichtung aufweist.

17. Kathodenverdampfungsmaschine nach Anspruch 13, bei welcher der Vorsprung (14b) zumindest teilweise Permanentmagnetmaterial aufweist.

## Revendications

1. Machine d'évaporation cathodique, comprenant une chambre d'évaporation (2) configurée pour loger une partie ou surface à revêtir (1), un ensemble cathodique comprenant un élément de cathode (3) et une anode (4),
l'ensemble cathodique et l'anode étant configurés et agencés de façon qu'un arc puisse être établi entre l'anode (4) et l'élément cathodique (3) pour provoquer une évaporation au moins partielle de l'élément cathodique (3),
l'ensemble cathodique comprenant en outre un système de guidage magnétique pour guider l'arc sur l'élément cathodique (3),
ledit système de guidage magnétique comprenant un dispositif magnétique comprenant un pôle central (14) et un pôle périphérique (12), et au moins un premier générateur de champ magnétique et un deuxième générateur de champ magnétique configurés pour produire des composants de champ magnétique respectifs contribuant à un champ magnétique total en correspondance avec l'élément cathodique (3), au moins ledit premier générateur de champ magnétique comprenant au moins une première bobine (13) agencée autour d'au moins une partie (14b) du dispositif magnétique et configurée pour produire le composant de champ magnétique correspondant dans ledit dispositif magnétique, de façon qu'en modifiant un courant à travers ladite première bobine (13), ledit champ magnétique total en correspondance avec ledit élément cathodique (3) peut être modifié,
le pôle périphérique (12) ayant une surface d'extrémité (12a) configurée de façon que le champ magnétique produit par le premier générateur de champ magnétique et le deuxième générateur de champ magnétique possède une intensité plus élevée en correspondance avec ladite surface d'extrémité (12a) qu'en correspondance avec des surfaces adjacentes du dispositif magnétique;
**caractérisée en ce que**
la distance (A) entre ladite surface d'extrémité (12a) et l'élément cathodique (3) est au moins de 20 mm.

2. Machine d'évaporation cathodique selon la revendication 1, dans laquelle ladite distance (A) est au moins de 30 mm.

3. Machine d'évaporation cathodique selon la revendication 2, dans laquelle ladite distance (A) est au moins de 40 mm.

4. Machine d'évaporation cathodique selon la revendication 3, dans laquelle ladite distance (A) est supérieure à 40 mm et inférieure à 150 mm.

5. Machine d'évaporation cathodique selon l'une quelconque des revendications précédentes, dans laquelle ladite surface d'extrémité (12a) est espacée d'une distance (B) d'au moins 10 mm du niveau le plus extérieur de l'élément cathodique (3), dans une première direction perpendiculaire audit niveau.

6. Machine d'évaporation cathodique selon l'une quelconque des revendications précédentes, dans laquelle ladite surface d'extrémité (12a) est espacée d'une distance (C) d'au moins 10 mm de l'élément cathodique (3), dans une direction parallèle à l'extension générale dudit élément cathodique (3).

7. Machine d'évaporation cathodique selon l'une quelconque des revendications précédentes, dans laquelle le dispositif magnétique comprend un support (15) ayant ledit pôle périphérique (12) et ledit pôle central (14), ledit support ayant une base (15a) à partir de laquelle une protubérance centrale (14b) formant ledit pôle central (14) s'étend.

8. Machine d'évaporation cathodique selon la revendication 7, dans laquelle le support comporte en outre une extension périphérique (12b) s'étendant de la base (15a) dans une direction sensiblement parallèle à la protubérance centrale (14b), ladite extension périphérique (12b) formant le pôle périphérique (12).

9. Machine d'évaporation cathodique selon la revendication 7 ou 8, dans laquelle ladite au moins une bobine (13) entoure ladite protubérance centrale (14b).

10. Machine d'évaporation cathodique selon la revendication 9, dans laquelle ladite protubérance centrale (14b) comprend un matériau ferromagnétique.

11. Machine d'évaporation cathodique selon l'une quelconque des revendications 7-10, dans laquelle ledit support (15) a une configuration généralement circulaire.

12. Machine d'évaporation cathodique selon l'une quelconque des revendications 7-11, dans laquelle le support (15) est réalisé en un matériau ferromagnétique.

13. Machine d'évaporation cathodique selon l'une quelconque des revendications 7-11, dans laquelle le support est réalisé en partie par un matériau ferromagnétique et en partie par un matériau d'aimant permanent, ledit deuxième générateur de champ magnétique comprenant ledit matériau d'aimant permanent.

14. Machine d'évaporation cathodique selon la revendication 13, dans laquelle le pôle périphérique (12) comprend un matériau d'aimant permanent.

15. Machine d'évaporation cathodique selon les revendications 9 et 16, **caractérisée en ce que** ledit matériau d'aimant permanent possède une direction d'aimantation perpendiculaire à la base.

16. Machine d'évaporation cathodique selon les revendications 9 et 16, **caractérisée en ce que** ledit matériau d'aimant permanent possède une direction d'aimantation à un angle aigu par rapport à la base.

17. Machine d'évaporation cathodique selon la revendication 13, dans laquelle ladite protubérance (14b) comprend au moins partiellement un matériau d'aimant permanent.
